# EUROPÄISCHE PATENTSCHRIFT

(11) **EP 0 808 460 B1**
(45) Veröffentlichungstag und Bekanntmachung des Hinweises auf die Patenterteilung: **13.10.1999**
(21) Anmeldenummer: 96901722.7
(22) Anmeldetag: 31.01.1996
(51) Int. Cl.: G01R 15/18

(54) **STROMERFASSUNGSSPULE FÜR EINEN STROMWANDLER**
CURRENT-DETECTION COIL FOR A CURRENT TRANSFORMER
BOBINE DE DETECTION DE COURANT POUR UN TRANSFORMATEUR

(30) Priorität: 09.02.1995 DE 19505812
(43) Veröffentlichungstag der Anmeldung: 26.11.1997
(73) Patentinhaber: SIEMENS AKTIENGESELLSCHAFT, 80333 München (DE)
(72) Erfinder: VON SKARCZINSKI, Albrecht, D-13587 Berlin (DE); MÖNCKE, Hartmut, D-13355 Berlin (DE)
(86) Internationale Anmeldenummer: DE9600216
(87) Internationale Veröffentlichungsnummer: WO9624855

(56) Entgegenhaltungen:
- EP-A- 0 339 189
- FR-A- 2 471 034

## Beschreibung

Die Erfindung betrifft eine Stromerfassungsspule für einen Stromwandler nach dem Rogowski-Prinzip mit einem elektrisch isolierenden Ringkörper als Träger für eine Wicklung, wobei die Querschnittsform des Ringkörpers am äußeren Umfang und am inneren Umfang einen abgeflachten Bereich aufweist.

Eine Stromerfassungsspule dieser Art ist durch die GB-Zeitschrift EPE-Journal, Vol. 3, Nr. 1, March 1993, Seiten 51 bis 59 bekannt geworden. Als Formen von Ringkörpern werden dort einfache feste Toroide oder biegsame und aufgeschnittene Spulenkörper vorgeschlagen. Ferner wird die Verwendung kreisförmiger aufgeschnittener Kunststoffringe mit rechteckigem Querschnitt empfohlen, die sich zur Anbringung an einem Leiter aufbiegen lassen und dann in die Ringform zurückkehren.

Obwohl alle vorstehend erwähnten Ausführungsformen von Stromerfassungsspulen mit unterschiedlichen Ringkörpern zur Bildung eines Rogowski-Stromwandlers mit gutem Übertragungsverhalten zu schaffen, ergibt sich bei serienmäßiger Fertigung die Schwierigkeit, das praktisch jedes hergestellte Exemplar andere Übertragungseigenschaften aufweist und daher individuelle Justierungen oder elektronische Korrekturschaltungen eingesetzt werden müssen, um zu gleichmäßigen Ergebnissen zu gelangen. Die Abhängigkeit des Übertragungsverhaltens von Rogowski-Stromerfassungsspulen von geringen Abweichungen ihrer geometrischen Beschaffenheit gegenüber der Idealform ist bekannt und hat bereits zu dem Vorschlag geführt, als Wicklungsträger gerade geschliffene Keramikstäbe zu benutzen (DE-Zeitschrift "Technische Mitteilungen AEG-Telefunken" 60 (1970) 7, Seiten 444 bis 448). Da eine Stromerfassungsspule nach dem Rogowski-Prinzip jedoch einen Leiter auf einer geschlossenen Bahn umgeben muß, erfordert somit die Verwendung gerader Keramikstäbe die Zusammensetzung einer geschlossenen Stromerfassungsspule aus vier Teilspulen. Dabei entstehen erhebliche Störungen im Feldverlauf durch das rechtwinklige Aneinanderstoßen der Teilstücke. Um diesen Einfluß zu erheben, werden die Stoßstellen durch eine Abschirmung feldfrei gemacht. Die gewünschte Präzision des Rogowski-Stromwandlers ist daher mit einem beträchtlichen Aufwand für die Fertigung der Stromerfassungsspulen verbunden.

Der Erfindung liegt hiervon ausgehend die Aufgabe zugrunde, eine Bauweise für eine Stromerfassungsspule eines Rogowski-Stromwandlers zu schaffen, die sich durch eine minimale Streuung ihrer Eigenschaften auszeichnet und die sowohl für laufende Strommessungen als auch für die Auslösung geeignet ist.

Gemäß der Erfindung wird diese Aufgabe dadurch gelöst, daß die verbleibenden Bereiche der Querschnittsform etwa halbkreisförmig ausgebildet sind, daß der Ringkörper aus einem faserverstärkten duroplastischen Kunststoff besteht und als massiver Vollkörper in einer teilbaren Form einstückig hergestellt ist, wobei der Ringkörper gratfrei hergestellt ist und keine Hinterschneidungen aufweist und daß die Wicklung mittels einer Ringkernwickelmaschine aufgebracht ist.

Der nach der Erfindung vorgesehene Ringkörper ist ein sehr stabiles Teil, welches eine hohe thermische Beständigkeit und zugleich einen nur geringen thermischen Dehnungsfaktor aufweist. Diese Eigenschaften führen dazu, daß sich die Form der Wicklung nur minimal ändert, wenn die Stromerfassungsspule beispielsweise an den Hauptstrombahnen eines Niederspannungs-Leistungsschalters angebracht ist, wo starke mechanische Erschütterungen und Temperaturen bis oberhalb 100°C auftreten können. Zu dieser Stabilität trägt die nur am inneren und äußeren Umfang abgeflachte Querschnittsform des Ringkörpers bei, welche das Widerstandsmoment gegen eine mechanische Verformung erhöht. Die gratfreie Herstellung des Ringkörpers trägt zu der gewünschten Gleichmäßigkeit und Güte der Wicklung dadurch bei, daß der Wicklungsdraht am gesamten Umfang des Ringkörpers satt anliegt und daher nicht verschoben oder deformiert werden kann.

Zum Einsatz in Niederspannungs-Leistungsschaltern im mittleren bis höheren Nennstrombereich eignet sich beispielsweise ein Ringkörper mit einem Außendurchmesser von etwa 80 bis 100 mm, der einlagig mit Kupferlackdraht von etwa 0,05 bis 0,1 mm Dicke dicht bewickelt ist.

Werden Stromerfassungsspulen nach der Erfindung in mehrpoligen Niederspannungs-Leistungsschaltern eingesetzt, so kann die Genauigkeit der Messung in den benachbarten Phasen durch die geringen Abstände der betreffenden Leiter beeinträchtigt werden. Dieser Einfluß hängt von der Güte der Wicklung der Stromerfassungsspulen ab. Im Rahmen der Erfindung können die störenden Einflüsse benachbarter Leiter dadurch begrenzt werden, daß gemäß einem Verfahren zur Herstellung der Stromerfassungsspule nach Anspruch 3, der Vorschub der Ringkern-Wickelmaschine konstant und so bemessen ist, daß bei gegebener Windungszahl zwischen dem Anfang und dem Ende der Wicklung eine Lücke von höchstens 0,5% des Umfangs des Ringkörpers verbleibt.

Die gratfreie Herstellung des Ringkörpers der Stromerfassungsspule kann im Rahmen der Erfindung durch eine Vorrichtung nach Anspruch 4 erleichtert werden, bei welcher die Teilfuge der Form in dem abgeflachten Bereich der Querschnittsform des Ringkörpers angeordnet ist. Durch diese Maßnahme wird einer Auswaschung der Teilfuge durch das Spritzgut und damit einer Gratbildung vorgebeugt. Nachträgliche Arbeitsgänge zur Entfernung eines evtl. entstandenen Grates sind daher entweder entbehrlich oder beschränken sich auf einen minimalen Aufwand.

Die Erfindung wird im folgenden anhand des in den Figuren dargestellten Ausführungsbeispieles näher erläutert.

Die Figuren 1 und 2 zeigen einen Ringkörper als Träger einer Stromerfassungspule in der Draufsicht und im Schnitt.

Die Figur 3 zeigt im Schnitt einen Teil einer zur Herstellung eines Ringkörpers gemäß den Figuren 1 und 2 dienenden Spritzform.

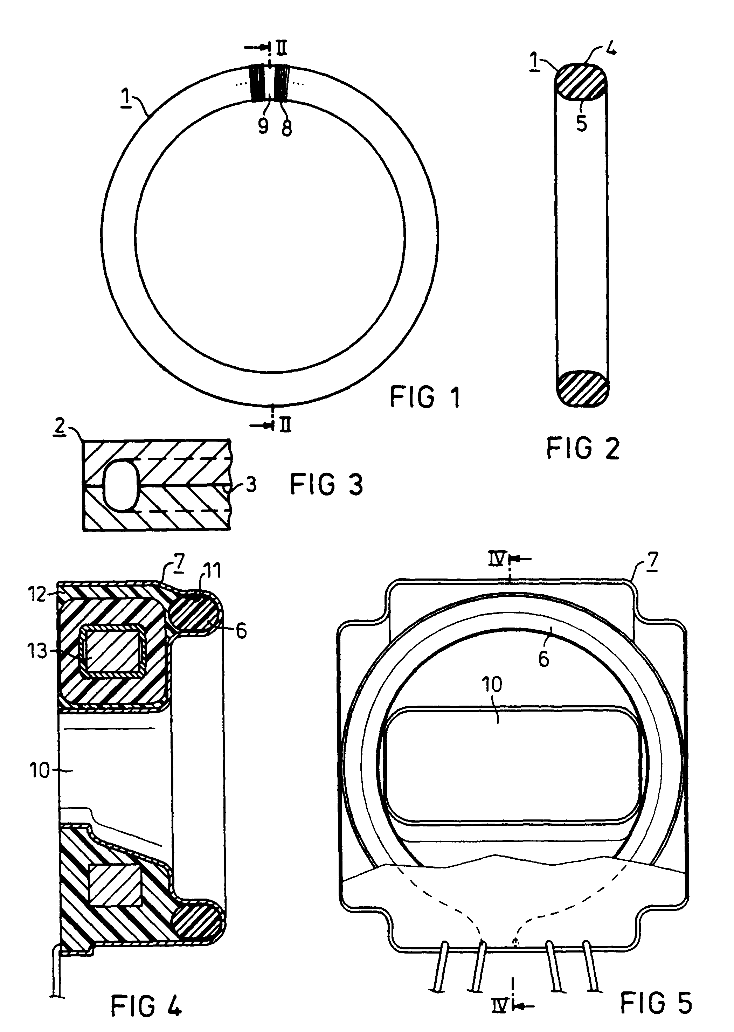

Ein Beispiel für die Anordnung einer Stromerfassungsspule zeigen die Figuren 4 und 5.

In den Figuren 1 und 2 ist ein Ringkörper gezeigt, der als Träger einer Wicklung für einen nach dem Rogowski-Prinzip arbeitenden Stromwandler dient. Der Ringkörper 1 weist eine am äußeren Umfang und am inneren Umfang abgeflachte Querschnittsform auf, wobei die verbleibende Kontur etwa halbkreisförmig ist. Zur Herstellung des Ringkörpers 1 dient eine in der Figur 3 gezeigte Form 2, deren Teilfuge 3 in dem äußeren abgeflachten Bereich 4 und dem inneren abgeflachten Bereich 5 der Querschnittsform liegt. Die Kunststoff-Spritzmasse des Ringkörpers 1 ist vorzugsweise eine mit kurzen Glasfasern gefüllte duroplastische Harzmischung auf Polyesterbasis. Diese ergibt Ringkörper 1 mit guter Maßhaltigkeit, Festigkeit gegen Verformung sowie sehr geringer Wärmedehnung unter dem Einfluß der im Betrieb auftretenden Temperaturen.

Der Anfang und das Ende der auf den Ringkörper 1 mittels einer Ringkern-Wickelmaschine aufzubringenden Wicklung 8 sind in der Figur 1 angedeutet. Wie man erkennt, besteht eine nur sehr kleine Lücke 9 zwischen Wicklungsanfang und Wicklungsende. Dies wird bei gegebener Windungszahl durch konstanten und passend bemessenen Vorschub der zur Herstellung benutzten Ringkern-Wickelmaschine erreicht. Durch den am ganzen des Ringkörpers 1 gleichen Abstand der Windungen und die prozentual auf den Umfang des Ringkörpers 1 bezogen sehr kleine Lücke 9 können sich Fehler, wie sie durch eine gegenseitige Verdrängung der Magnetfelder benachbarter Phasen in einem Niederspannungs-Leistungsschalter auftreten können, nur minimal auswirken. Im Ergebnis ist die fertiggestellte Stromerfassungsspule in der Lage, einen Strombereich meßtechnisch zu beherrschen, der bei wenigen A beginnt und bis etwa 150 kA reicht. Insbesondere die untere Meßgrenze wird nicht nur durch die Eigenschaften der Stromerfassungsspule, sondern auch durch die Eigenschaften einer elektronischen Auswertungsschaltung bestimmt, an welche die Stromerfassungsspule anzuschließen ist. Daher ist ab etwa 50 A mit einer zuverlässigen Strommessung zu rechnen.

Durch die Lage der Teilfuge 3 in den Bereichen 4 und 5 des Ringkörpers 1 (Figur 2) besteht nur eine geringe Neigung zur Gratbildung bei der Herstellung. Sollte dennoch Grat entstehen, so empfiehlt es sich, diesen durch eine nachträgliche Bearbeitung zu entfernen, bevor mittels einer Ringkernwickelmaschine die vorgesehene Wicklung auf dem Ringkörper 1 aufgebracht wird. Soll der gesamte Bereich vorkommender Ströme durch eine einzelne Wicklung erfaßt werden, so muß die Wicklung eine große Zahl von Windungen aufweisen. Dementsprechend ist es erforderlich, einen Spulendraht mit sehr geringem Durchmesser einzusetzen. Ein Ringkörper von beispielsweise 100 mm Außendurchmesser und einem Querschnitt von etwa 8x12 mm kann dabei mit etwa dreitausend Windungen eines Kupferlackdrahtes von 0,07 mm Dicke bewickelt werden.

Eine fertige Stromerfassungsspule 6 kann in der Weise angeordnet sein, wie dies die Figuren 4 und 5 zeigen. Die dort gezeigte Spulenanordnung weist ein einseitig offenes Gehäuse 7 auf, das ein mittleres Fenster 10 zum Durchtritt eines schienenförmigen Leiters eines Leistungsschalters besitzt. Die unter Verwendung des Ringkörpers 1 gemäß den Figuren 1 und 2 hergestellte Stromerfassungsspule 6 befindet sich in einem Ringraum 11 des Gehäuses 7 und ist mittels einer Vergußmasse 12 befestigt und abgedeckt. Die gleiche Vergußmasse 12 dient zur Festlegung eines zusätzlichen induktiven Stomwandlers 13, der einschließlich der Vergußmasse 12 in der Figur 5 fortgelassen ist. Der Stromwandler 13 kann beispielsweise dazu dienen, eine Hilfsenergie bereitzustellen, die zum Betrieb einer mit der Stromerfassungsspule 6 zu verbindenden elektronischen Auswertungsschaltung benötigt wird. Ferner kann ein elektronischer Auslöser mittels des Stromwandlers 13 betrieben werden.

## Patentansprüche

1. Stromerfassungsspule (6) für einen Stromwandler nach dem Rogowski-Prinzip mit einem elektrisch isolierenden Ringkörper (1) als Träger für eine Wicklung, wobei die Querschnittsform des Ringkörpers (1) am äußeren Umfang und am inneren Umfang abgeflachte Bereiche (4, 5) der Querschnittsform aufweist, **dadurch gekennzeichnet,** daß die verbleibenden Bereiche der Querschnittsform etwa halbkreisförmig ausgebildet sind, daß der Ringkörper (1) aus einem faserverstärkten duroplastischen Kunststoff besteht und als massiver Vollkörper in einer teilbaren Form (2) einstückig hergestellt ist, wobei der Ringkörper (1) gratfrei hergestellt ist und keine Hinterschneidungen aufweist und daß die Wicklung mittels einer Ringkern-Wickelmaschine aufgebracht ist.

2. Stromerfassungsspule nach Anspruch 1,
**dadurch gekennzeichnet,** daß der Ringkörper (1) bei einem Außendurchmesser von etwa 80 bis 100 mm einlagig mit Kupferlackdraht von etwa 0,05 bis 0,1 mm Durchmesser dicht bewickelt ist.

3. Verfahren zur Herstellung einer Stromerfassungsspule nach Anspruch 1 oder 2,
**dadurch gekennzeichnet,** daß der Vorschub der Ringkern-Wickelmaschine konstant und derart bemessen ist, daß bei gegebener Windungszahl die Lücke zwischen dem Anfang und dem Ende der Wicklung 0-0,5% des Umfanges des Ringkörpers (1) beträgt.

4. Vorrichtung zur Herstellung des Ringkörpers (1) der Stromerfassungsspule (6) nach Anspruch 1,
**dadurch gekennzeichnet, daß** die Teilfuge (3) der Form (2) in den abgeflachten Bereichen (4, 5) der Querschnittsform des Ringkörpers (1) angeordnet ist.

## Claims

1. Current detection coil (6) for a current transformer based on the uniform field principle, having an electrically insulating annular former (1) as a base for a winding, wherein the cross-sectional shape of the annular former (1) has flattened regions (4) on the outer circumference and flattened regions (5) on the inner circumference of the cross-sectional shape, characterized in that the remaining regions of the cross-sectional shape are designed to be approximately semicircular, in that the annular former (1) is composed of a fibre-reinforced thermosetting plastic and is produced integrally as a solid body in a mould (2) which can be split, in which case the annular former (1) is produced without any burrs and has no undercuts, and in that the winding is applied by means of an annular-core winding machine.

2. Current detection coil according to Claim 1,
characterized in that the annular former (1) has an external diameter of about 80 to 100 mm and is wound tightly with a single layer of varnished-copper wire with a diameter of about 0.05 to 0.1 mm.

3. Method for producing a current detection coil according to Claim 1 or 2,
characterized in that the feed rate of the annular-core winding machine is constant and is of such a magnitude that, for a given number of turns, the gap between the start and the end of the winding is 0-0.5% of the circumference of the annular former (1).

4. Apparatus for producing the annular former (1) of the current detection coil (6) according to Claim 1,
characterized in that the separating joint (3) of the mould (2) is arranged in the flattened regions (4, 5) of the cross-sectional shape of the annular former (1).

## Revendications

1. Bobine (6) de détection de courant pour un transformateur de courant travaillant suivant le principe de Rogowski, comportant comme support pour un enroulement un élément (1) annulaire isolant du point de vue électrique, la forme de section transversale de l'élément (1) annulaire comportant sur le pourtour extérieur et sur le pourtour intérieur des zones (4, 5) aplaties de la forme de section transversale, caractérisée en ce que les zones restantes de la forme de section transversale sont conformées de manière à peu près hémicirculaire, en ce que l'élément (1) annulaire est en une matière plastique thermodurcissable renforcée par des fibres et est produit d'une pièce comme élément plein massif dans un moule (2) divisible, l'élément (1) annulaire étant produit sans bavure et ne comportant pas de contre-dépouille, et en ce que l'enroulement est monté au moyen d'une bobineuse pour noyaux toroïdaux.

2. Bobine de détection de courant suivant la revendication 1, caractérisée en ce que l'élément (1) annulaire est, pour un diamètre extérieur d'environ 80 à 100 mm, entouré étroitement sur une couche de fils en cuivre émaillé d'un diamètre d'environ 0,05 à 0,1 mm.

3. Procédé pour fabriquer une bobine de détection de courant suivant la revendication 1 ou 2, caractérisé en ce que l'avance de la bobineuse pour noyaux toroïdaux est constante et prévue de manière que, pour un nombre de spires donné, le vide entre le début et l'extrémité de l'enroulement soit de 0 à 0,5 % du pourtour de l'élément (1) annulaire.

4. Dispositif pour fabriquer l'élément (1) annulaire de la bobine (6) de détection de courant suivant la revendication 1, caractérisé en ce que le joint (3) du moule est monté dans les zones (4, 5) aplaties de la forme de section transversale de l'élément (1) annulaire.
